(19) Europäisches Patentamt
European Patent Office
Office européen des brevets

(11) **EP 4 579 509 A1**

(12) **EUROPEAN PATENT APPLICATION**

(43) Date of publication:
**02.07.2025 Bulletin 2025/27**

(21) Application number: **24223800.4**

(22) Date of filing: **30.12.2024**

(51) International Patent Classification (IPC):
**G06F 30/17** (2020.01)    **G06F 30/23** (2020.01)

(52) Cooperative Patent Classification (CPC):
**G06F 30/23; G06F 30/17**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.12.2023 EP 23220855**

(71) Applicant: **Technische Universität Darmstadt
64289 Darmstadt (DE)**

(72) Inventors:
• **Schillinger, Dominik
  64289 Darmstadt (DE)**
• **Hiemstra, René R.
  64289 Darmstadt (DE)**

(74) Representative: **Zahn, Matthias et al
Peter Bittner und Partner
Herrenwiesenweg 2
69207 Sandhausen (DE)**

(54) **DESIGN APPROACH FOR REAL-WORLD OBJECTS INVOLVING COMPUTER SIMULATION THAT APPLIES QUADRATURE TECHNIQUES**

(57)    A simulation computer predicts the shape (200) of a real-world object as a result of hypothetical force application to the real-world object. The computer calculates individual integrals with a trial function and a test function by applying quadrature rules with quadrature weights ($W\_i\_r$) that are specific to the individual basis function and that are specific to the parameter set that corresponds to interpolation points of the individual basis function. The weights (220, 230) are pre-calculated and fit to exactness conditions.

FIG. 2

**Description**

**Technical Field**

In general, the disclosure relates to the use of computers in the design process for products. In particular, the disclosure relates to a simulation computer and to a computer-implemented method to predict the shape of a real-world object following an expected but hypothetical application of a mechanical force to the object.

**Background**

Product manufacturers evaluate the behavior of their products (or products that are to be manufactured in the future) under situations in that mechanical forces act on the products.

For many use-case scenarios, the products are assemblies of components. Components can have sub-components, and there can be further hierarchy levels. The terminology may vary. For example, one can differentiate products, components, parts, and so on.

Product designers have questions. For example, how do products (or their components) change during force application. Or - simplified - the designers need to know the "before-and-after" difference. As many products are designed for use by humans, further questions are related to safety hazards, during or after force application.

The following examples illustrate activities to answer these and other questions:

- Vehicle manufacturers engage experts that perform crash-test experiments. The products are vehicles, and the crash-tests anticipate mechanical forces that act on the vehicles during accidents.
- In the military field, the experts conduct explosion experiments to understand the effects of exploding ammunition or the like. The effects relate to the ammunition and to the targets.
- In other industrial areas, manufacturers provide products by applying so-called forming processes, among them metal forming and metal stamping. In many cases, the manufacturers are interested in setting up production lines that guarantee products with pre-defined quality. Experts conduct experiments as well.

In general, the experts hand over experimental results to the product designers. In case of design changes (in response to experimental results), some of the experiments would have to be repeated.

To avoid experiments in the real world, the manufacturers represent their products (and components) by computer data and simulate force application by computers. In other words, crash tests turn into crash simulations, real explosions turn into blast simulations and so on. Other processes, such as forming processes can be simulated as well.

Just to name a very simple example, a product might be a hook that can be formed from a piece of wire or that can be formed from a sheet of metal. The manufacturer needs to know what load such a hook might be able to lift or to support.

During the simulation, a simulation computer processes data that represent the shape of the products (or of its components). Ideally, shape data would correspond to reality, and the result of the simulation would accurately correspond to the result of a real-world experiment. In other words, the simulation computer would render images that would look like "before-and-after" photographs taken during the experiments.

However, simulations can only approximate the reality. To answer the above and other questions, the accuracy of the simulations must be sufficient. Accuracy depends on the computer representation's granularity in space and in time.

Regarding space, the simulation computer virtually divides the products (and its components) into elements that form a mesh. Time is divided into time-steps. This process is called spatial discretization or time discretization, respectively.

Virtually dividing things into so-called finite elements has been practiced in the art for decades (finite element analysis, FEA). Isogeometric analysis is a more recent FEA technology that incorporates directly the geometry representations from a Computer-Aided-Design (CAD) model, typically represented by splines. Simplified, a spline is a mathematical construct that describes a 2D curve (or a 3D surface or volume) by piecewise polynomial functions that interface smoothly between the pieces (or elements). The construct uses one or more parameters in a parameter range, and the polynomials can change for sub-ranges of the parameters. The constructs also use so-called basis functions that the skilled person usually denote by uppercase letters "B" or "N".

Examples for such constructs comprise Bézier functions, basis splines ("B-splines" in short), and Non-Uniform Rational B-splines ("NURBS" in short). The skilled person is familiar with the relations between these examples.

The simulation computer processes shape data for multiple consecutive discrete time-points (that define time-steps) during the simulated force application. Simplified, increasing the granularity (more elements or higher polynomial order in space, more time-points) increases the simulation accuracy but also increases the computational expense.

Of course, the simulation computer does not process shape data alone, but also data regarding product properties, data regarding the force application and so on.

The skilled person is familiar with the mathematics. For example, the simulation computer solves coupled equation systems, which may represent physical properties of the products as distributed over shape. For example, the equation systems can have matrices, and the equation systems allow processing data that represents physical phenomena such as acceleration, mass and so on. In other words, the simulation computer can process discrete equations that relate to dynamic motion and deformation (of the product or its components).

Processing the equation systems involves processing partial differential equations (PDEs), and involves the estimation of integrals. A convenient approach to approximate the integral J of a function $\varphi(x)$ is known as a "quadrature rule" or a "quadrature routine". Much simplified, the integral J is approximated by the sum $\Sigma$ of a number N of (mathematical) products between weights $W\_n$ and associated function evaluations $\varphi(x\_n)$ evaluated for certain parameter values $x\_n$ only. The parameter values $x\_n$, with $n = 1$ to $n = N$, are called "quadrature points" and the $W\_n$ are called quadrature weights.

Gaussian quadrature rules are classical techniques where the definition of the weights and points are chosen to yield an exact result for polynomials of degree 2N-1 or less. Their properties are closely related to properties of certain sets of polynomials (e.g., Legendre, Lobatto, Jacobi, Chebyshev). As the naming after famous mathematicians suggests, Gaussian quadrature techniques have been developed many decades (and even centuries) ago and are well documented in textbooks or the like.

Weighted quadrature is a recent technique developed specifically for approximating certain integrals involving products of two spline functions for use in isogeometric analysis. Weighted quadrature is introduced in the following papers: (a) Calabrò, F.; Sangalli, G.; Tani, M.: Fast formation of isogeometric Galerkin matrices by weighted quadrature, Computer Methods in Applied Mechanics and Engineering, 316:606-622, 2017, doi: 10.1016/j.cma.2016.09.013. *(b)* Hiemstra, R.R., Sangalli, G., Tani, M., Calabrò, F. and Hughes, T.J., 2019. Fast formation and assembly of finite element matrices with application to isogeometric linear elasticity. Computer Methods in Applied Mechanics and Engineering, 355, pages 234-260.

In weighted quadrature, the increased smoothness of splines (compared to regular piecewise polynomials) is used in a way to minimize the number of quadrature points needed for stability and accuracy of computations. Nevertheless, approaches developed in the above cited works still require about 2 times in 1D, 4 times in 2D or 8 times in 3D (i.e., two to the power of the dimension) the theoretical minimum of quadrature points needed for stability and accuracy.

The computational resources (time and number of processors including memory use) needed to perform a simulation (called the computational cost or expense) is roughly dependent on: (1) the resulting size and properties of the matrix problem; (2) the number of time-steps needed to simulate the evolution due to force application; (3) the total number of required quadrature points of the used quadrature rules.

The total number of quadrature points generally has a significant effect on the duration of computer simulations based on FEA or IGA. In certain applications it is the dominant factor in the overall computations. To reach a certain level of accuracy in simulation, the spatial resolution of the finite element (or isogeometric) mesh needs to be sufficiently small leading to a high number of finite elements (typically in the millions). Every finite element is associated to at least one quadrature point, but typically associated to more than one quadrature points. The constitution (material response), kinematics (motion related properties) and kinetics (force related properties) are evaluated in each quadrature point. The total cost of evaluation per quadrature point times the total number of quadrature points N may be excessive and dominate the computational time in numerical simulation of physical processes. This is specifically the case in higher dimensions (i.e. 2D or 3D) where the number N grows quadratically in 2D or cubically in 3D.

The skilled person understands that the simulation duration is only one aspect in computation efficiency. Any calculation (such as of a product, of a sum or the like) requires computers to use resources, such as memory (e.g., random access memory RAM) or processing resources (central processing unit CPU, graphical processing unit GPU). Shortening the simulation duration and reducing computational complexity is considered to have paramount importance.

From the viewpoint of the above-mentioned product manufacturers, speeding up the work for simulation specialists (i.e., the users of the simulation computers) would allow the manufacturers to develop and to evaluate their products in less time. However, speeding up must not be at the expense of simulation accuracy.

## Summary

A simulation computer executes a (computer-implemented) method to predict the shape of a real-world object following hypothetical force application to the real-world object. The simulation computer processes object-descriptive data and processes force-descriptive data. Object-descriptive data are data that represent the shape of the object and represent properties of the object at particular shape positions.

A computer-implemented method is provided to predict the shape of a real-world object as a result of hypothetical force application to the real-world object. The real-world object is expected to be converted from an initial object having an initial shape into a final object having a final shape. The method is implemented by a simulation computer that represents the shape of the object by basis functions with a parameter in a parameter range from a start parameter value to an end parameter value, and that calculates individual integrals for individual basis functions (INTEGRAL_i = $\int$ f(x) * B_i(x) dx | x in [a, b]). The integrand is the product of a property function f(x) that describes a property of the object at positions as a trial function, and an individual basis function B_i(x) as a test function. The simulation computer calculates the individual integral by applying quadrature.

The simulation computer calculates the individual integrals by applying quadrature according to $\Sigma$ f(x_r)*W_i_r | r = 1 to r = R being the sum of R products of quadrature weights W_i_r that are specific to the individual basis function B_i(x) and that are specific to the parameter set x_r that corresponds to interpolation points of the individual basis function B_i(x) within the parameter range and particular values of the property function f(x_r) at the quadrature point x_r.

Optionally, the simulation computer obtains the quadrature weights that are specific to the individual basis function by selecting the quadrature weights from pre-defined weight sets.

Optionally, selecting the quadrature weights from pre-defined weight sets comprises analyzing the property function to identify descriptors of the property function, and selecting the weight set according to the descriptors.

Optionally, the descriptors comprise: the polynomial degree of the basis functions that in combination represents the shape of the object, and indications of the applicability of particular basis functions for particular parameter sub-ranges of the parameter range.

Optionally, the simulation computer determines the interpolation points of the individual basis function within the parameter range by evaluating the sub-intervals.

Optionally, the simulation computer determines the interpolation points as the Greville points or as the Chebyshev-Demko points.

Optionally, the simulation computer receives the indication of the applicability of particular basis functions as a knot vector.

Optionally, the simulation computer calculates the integrals, starting with the initial shape, and uses the calculated integrals for further calculations that process data that describe the force application.

Optionally, the simulation computer calculates the individual integrals as part of calculations with calculating the mass of the object for further calculating the displacement of the object due to the force application.

Optionally, the simulation computer represents the shape of the object by the basis functions to represent the object by B-splines or by NURBS.

Optionally, the simulation computer applies the results of calculating the integrals to update the shape from the initial shape, via intermediate shapes to the final shape.

Using the method is explained as part of the design process of the real-world object. The simulation computer receives the at least one shape representation from a CAD computer.

Using the method in also possible in the design process of a multi-object product, wherein the simulation computer performs the method is parallel for multiple real-world objects that belong to the multi-object product.

A computer program product that, when loaded into a memory of a computer system and executed by at least one processor of the computer system, causes the computer system to perform the steps of a computer-implemented method.

A computer system comprises a plurality of function modules which, when executed by the computer system, perform the steps of a computer-implemented method.

### Brief Description of the Drawings

FIG. 1 illustrates a real-world object in two virtual divisions;
FIG. 2 illustrates the application of force to an object, the operation of a simulation computer, as well as a time-diagram;
FIG. 3 illustrates an approach to represent the shape of an object by the combination of a set of basis functions;
FIG. 4 illustrates the calculation of an integral, wherein the simulation computer calculates the integral as the sum of products that comprise quadrature points and weights, according to traditional quadrature;
FIG. 5 illustrates the calculation of an integral, wherein the simulation computer calculates the integral as the sum of products that comprise quadrature weights, according to modified weighted quadrature;
FIGS. 6A and 6B illustrate a calculation that results in quadrature weights for the modified weighted quadrature rule that satisfies a set of exactness conditions;
FIGS. 7A and 7B illustrate an object that belongs - in various hierarchy stages - to a product, and also symbolizes modified weighted quadrature;
FIG. 8 illustrates a flow chart of a design process, and illustrates a simulation by the simulation computer that executes a computer-implemented method to predict the shape of the object; and
FIG. 9 illustrates a generic computer.

### Detailed Description

**Introduction**

A simulation computer processes a representation of the shape, called mesh, which is a division into simpler basic shapes called finite elements, and the computer processes integral quantities that are defined on the mesh. The simulation computer approximates these integrals within so-called machine precision using a quadrature rule, which is a weighted sum of function evaluations at so called quadrature points. The mesh may consist of millions of finite elements and each element has one, but typically many more quadrature points. Object- and force-descriptive data is evaluated at each quadrature point. The total computational expenses of quadrature can be estimated as the product of the expense per quadrature point and the number of quadrature points. In certain applications, it may dominate the overall computational expenses of the simulation.

Research and development of new quadrature techniques has largely focused on developing quadrature rules that achieve a sufficient level of accuracy with as few quadrature points as possible. This is generally achieved by exploiting a specialized form or specialized properties of the integrand (i.e., the function to be integrated). Weighted quadrature is one such technique, which exploits two properties: (a) The integrand is always a product of two functions: a so-called trial function and a so-called test function. The weights in a weighted quadrature rule are specific to each separate test function. (b) Both functions are piecewise polynomial functions with a high level of smoothness, called splines.

The resulting quadrature rule is determined by fixing a set of quadrature points according to a set of requirements. A requirement is that the quadrature rule can exactly reproduce the integrals of a large set of representative integrands, in this case splines. The requirement is also called "the exactness conditions for moment fitted quadrature".

The following description relates to a modified weighted quadrature rule. Specifically, the requirements regarding positioning of quadrature points are relaxed such that fewer points (roughly half in 1D, a quarter in 2D and one eight in 3D, compared to modified quadrature) are needed to satisfy the same exactness conditions. The savings in the total number of quadrature points directly translate to significant savings in computational expense in computer simulation.

**Conventions**

The description explains a computer-implemented method to predict the shape of a real-world object as a result of a hypothetical force application to the real-world object. The computer that executes the method is the simulation computer,

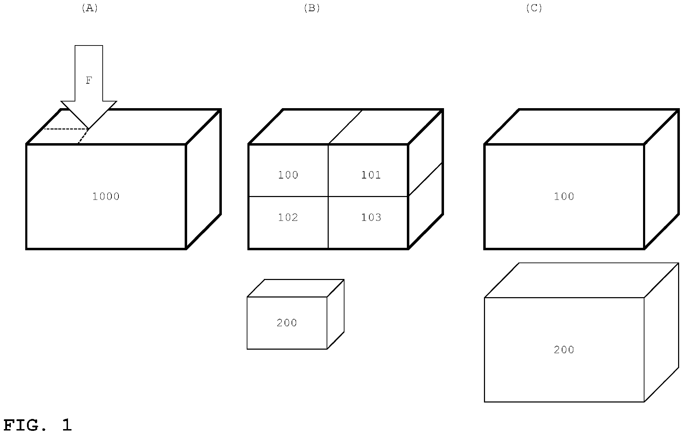

FIG. 1 illustrates real-world object 1000 in two virtual divisions. Section (A) of FIG. 1 illustrates real-world object 1000 and force F just before application. Section (B) illustrates real-world object 1000 being virtually divided into object parts 100, 101, 102 and 103, and section (C) illustrates real-world object 1000 having object part 100 only (no virtual division).

The virtual divisions are related to the prediction. The simulation computer executes the method for the object parts separately, by processing data that represents shape 200. As in section (B), the computer processes the shapes for different object parts, separately in different method execution instances. The figure takes shape 200 for object part 100 by way of example. The computer would also process the shape for object parts 101, 102 and 103. As in section (C), the computer processes shape 200 of object part 100 (that is identical to object 1000).

Real-world object 1000 can be a thing that has been manufactured (or that is to be manufactured), and object 1000 could therefore be a production object.

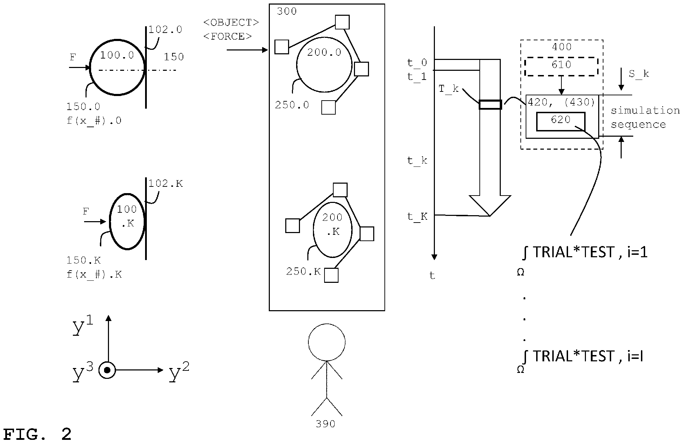

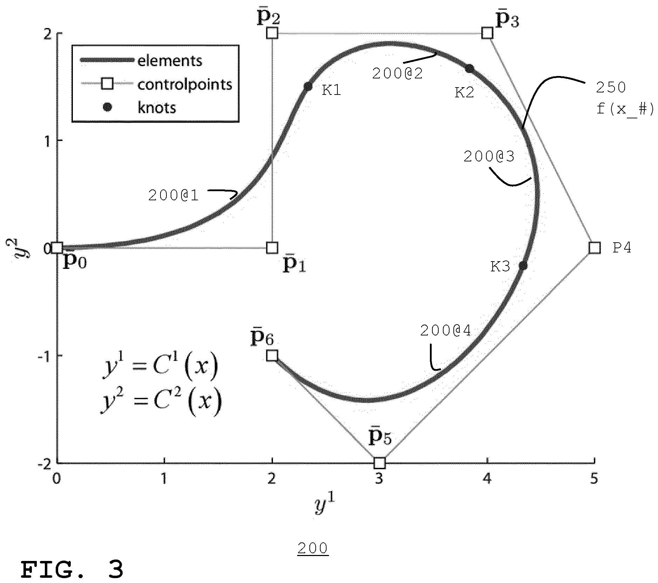

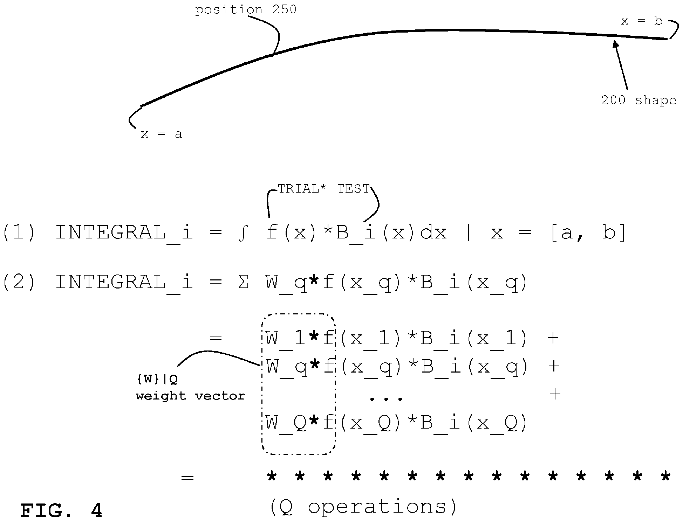

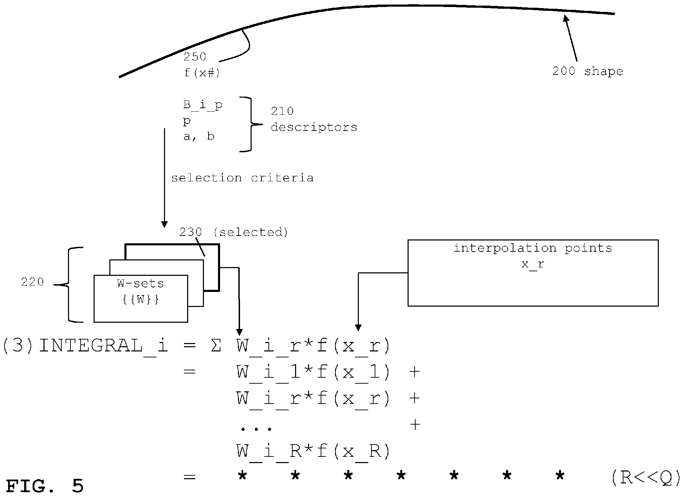

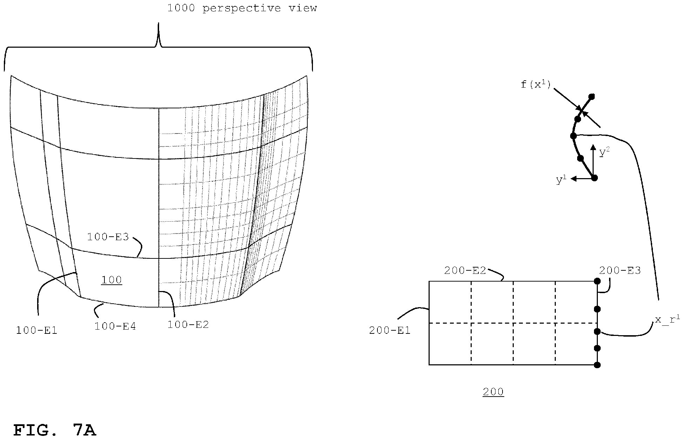

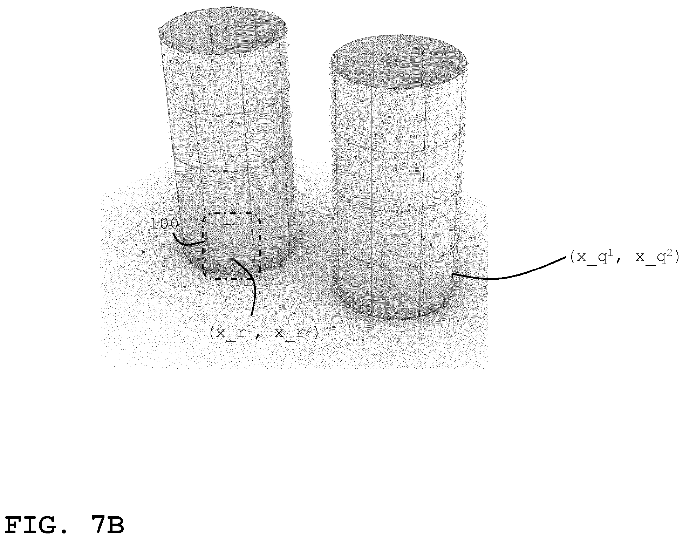

The description uses examples at different granularities: a vehicle (in the text only), a sphere (FIG. 2), a hook (FIG. 3), a piece of wire or foil (FIG. 4 and FIG. 5), a car hood (or bonnet, FIG. 7A), or a tube (FIG. 7B). The sphere, hook, wire or foil examples are examples for section (C) without division, and the example for the vehicle and for the car hood has the division of section (B).

For simplicity of explanation, the description writes "object 100", as object 100 belongs to object 1000 (either being identical (C) or being part thereof (B)), object 100 is also a real-world object.

The following description of FIG. 2 occasionally points to other figures that provide further details and illustrates further aspects.

**Object and shape**

FIG. 2 illustrates, simplified, from left to right: the application of a mechanical force F to real-world object 100, leading to its deformation, from initial object 100.0 to final object 100.K; the operation of simulation computer 300 that simulates the deformation, wherein shape 200 (or "geometry" 200, or "model") represents object 100, from initial shape 200.0 to final shape 200.K, cf. FIG. 1; and a time-diagram for the deformation as well as a simplified flow-chart diagram for the simulation.

Simulation user 390 is the human user of simulation computer 300. Simulation user 390 needs to know what happens to object 100 (or rather what would happen) during force application. Such knowledge regarding the deformation allows answering some of the above-mentioned questions that the product designers have.

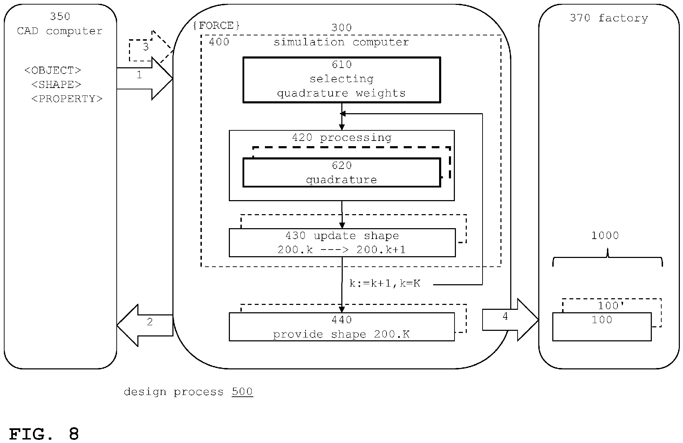

In many situations, simulation user 390 would cooperate with the product designer. The simulation can be part of an overall design process (cf. FIG. 8). The roles of simulation user 390 and of the product designer can be performed by the same person.

FIG. 2 further shows a coordinate system. In the example, object 100 has three physical dimensions (dimension d = 3, or 3D in space), here symbolized by a Cartesian coordinate system $(y^1, y^2, y^3)$. In some cases, it can be advantageous to use two coordinates only (d = 2; 2D; $y^1, y^2$). Other coordinate systems can be applied as well, such as cylindrical or spherical coordinate systems. Although FIG. 2 illustrates a particular coordinate system, this does not mean that simulation computer 300 uses such a coordinate system.

The coordinates allow the identification of object positions 150 (and of shape positions 250). Due to deformation, initial object position 150.0 is different from final object position 150.K. The same distinction applies to initial shape position 250.0 and final shape position 250.K. In general, the description can indicate the progress of time by adding a dot "." and a time index k.

Identifying positions 150/250 is not limited to coordinates. As it will be explained below, it is advantageous to describe shape 200 (and shape positions 250) by functions with a parameter (such as parameter x). For such shape-describing functions, the skilled person can apply a variety of formats, among them the above-mentioned B-splines, NURBS, and others. FIG. 3 gives an example.

Functions to describe the shape usually comprise linear combinations of so-called basis functions (a weighted sum of elementary functions). B-splines are basis functions for splines, which are piecewise polynomials that meet with a certain continuity between pieces. B-splines are defined using certain descriptors (such as the parameter range, the partitioning into sub-ranges also called elements, the smoothness between sub-ranges, and the polynomial degree, cf. descriptors 210 in FIG. 5, also FIG. 3)

FIG. 2 shows object 100 and its shape by a circle (for time index k = 0) and by an ellipse (for k = K). The figure thereby symbolizes that objects/shapes usually comprise one or more curves (or surfaces and volumes). FIG. 2 is much simplified, the shapes are not limited to such ideals such as circles: the curvature can be different for different positions, and different curvatures would be represented by basis functions having certain polynomial degrees.

## Property function

As describing the shape with linear combinations of basis functions is known in the art, the description simplifies the notation by introducing a property function f(x) with parameter x to describe one or more properties of object 100 at positions 150 (hence shape positions 250).

Applying a particular parameter value x to f(x) also allows to calculate the coordinates. For example, any position on shape 200.k corresponds to a particular parameter value x, and any parameter value x identifies a position 250-k.

FIG. 2 shows arbitrary positions 250.0 and 250.K that are associated with an arbitrary parameter value x_#. Property function f(x) has different values, here illustrated as a initial value f(x_#).0 and as a final value f(x_#).K.

## Convention regarding the parameter

Simulation computer 300 processes parameter x by discrete values (numeric values in floating point format or the like). In other words, the indication of positions is a discretization of a parameter.

A simplification (that is convenient for explanation) is the assumption that parameter x can be one-dimensional parameter. It is however possible - and well known in the art - to use multi-dimensional parameters. Such a multi-dimensional parameter can be written as a tuple $(x^1, x^2, x^3)$, here for three dimensions d = 3. The superscripts have nothing to do with powers or the like, they are just indices. The indication of positions with tuples is therefore a three-dimensional discretization. Using two dimensions (d = 2) is possible as well.

The parameter notation applies to the property function f(x) as well: $f(x^1, x^2, x^3)$ would be the property function in 3D.

It is also convenient to occasionally identify the plurality of substantially all positions (i.e., object 100 as a whole) by the spatial domain $\Omega$. Simulation computer 300 can represent spatial domain $\Omega$ by coordinates (such as $y^1, y^2$, etc.) or by parameters (such as x, $x^1$, $x^2$ etc.).

## Calculation overview

Processing by simulation computer 300 (such as to predict the shape) comprises the calculation of integrals J of products * of so-called trial functions with so-called test functions over the spatial domain $\Omega$ (i.e., $\int$ TRIAL * TEST $|\Omega$). The spatial domain $\Omega$ can be identified by parameters (e.g., x in 1D, $(x^1, x^2)$ in 2D, $(x^1, x^2, x^3)$ in 3D) within pre-defined ranges (that are related to the shapes).

Both the trial function (TRIAL) and the test function (TEST) comprise the above-mentioned basis functions (or their derivatives), and the basis functions can be standardized. Calculation routines for computers to calculate functional values for basis functions and their derivatives are available in off-the-shelf libraries.

It is also known in the art that calculating integrals can be implemented by approximating the integral as a weighted sum of function evaluations (i.e., values calculated by TRIAL * TEST). This is known as a "quadrature rule" or "quadrature routine" or often simply as "quadrature". A quadrature rule comprises a set of points in a parameter range and a corresponding set of weights.

However, the calculations of such J TRIAL * TEST integrals require computations. Much simplified, such computations translate into waiting time for user 390. There are several approaches to speed up computing, which are introduced in the following.

**Speed-up approaches**

The quadrature rules can be pre-calculated so that simulation computer 300 can select suitable points and weights (i.e., a selected pre-defined weight set) from a predefined set (cf. FIG. 5, sets 220 and 230).

The modified quadrature rules achieve the theoretical minimum number of quadrature points required for stability and accuracy of numerical integration, which is equal to the number of points in spline interpolation.

The modified quadrature rules process the numerical integrals, INTEGRAL_i = TRIAL * TEST_i, for an entire macro-element (i.e., shape 200) simultaneously (in contrast to traditional rules that process element-by-element). This is done using an algorithm called sum factorization, which scales well on heterogeneous compute nodes, including GPU's.

The modified quadrature rules are designed specifically for matrix-free computations in iterative solution techniques

**Method overview**

As already mentioned, simulation computer 300 executes (computer-implemented) method 400 to predict the shape 200.K of real-world object 100 following the hypothetical application of force F. Final shape 200.K is the result of force application.

From a high-level perspective, simulation computer 300 processes data that describes object 100 and processes data that describes the force application.

The description uses the conventions <OBJECT> data for object-descriptive data, and <FORCE> data for force-descriptive data. Object-descriptive data <OBJECT> have several aspects, such as the distribution of one or more object properties across its shape 200. Occasionally, the description differentiates these aspects, so that <OBJECT> comprises <SHAPE> data and <PROPERTY> data. The convention < > also comprises that data can be processed in the format with basis functions.

As a side-note, <FORCE> data has aspects as well. For example, the distribution of force application can vary across shape 200. Optionally, the distribution could be processed likewise.

As illustrated, method 400 comprises the steps

- optionally, selecting the quadrature rules 610 (from pre-defined quadrature rules, cf. the speed-up approach, step shown as optional by a dashed box),
- processing object-and-force data 420, with sub-step 620 (applying modified weighted quadrature to calculate individual integrals INTEGRAL_i = J TRIAL * TEST_i, that comprise the property function f(x), cf. formula 1 explained below), and
- optionally - updating shape data 430 (i.e., updating the data that describes the shape, <SHAPE> data, that belong to <OBJECT> data).

Steps 610 and 620 are illustrated by bold rectangles, because modified weighted quadrature is relevant here. The phrase "processing object-and-force data" is short for simulation computer 300 processing object-descriptive data <OBJECT> and - optionally - force-descriptive data <FORCE>. As the skilled person is familiar with shape simulation, the description can be short by simply writing INTEGRAL_i.

The sequence of steps 420 and 430 (step 420 including sub-step 620) is called "simulation sequence". Simulation computer 300 performs one simulation sequence 420/430 during one sequence slot that has the duration $S_k$. Simulation sequences 420/430 would usually be repeated (cf. FIG. 8). As used herein, the performance of K simulation sequences 420/430 is called "simulation instance".

The skilled person uses an appropriate number K (of simulation sequences), to reach a desired simulation accuracy. The skilled person understands that the repetition of steps 420/430 may eventually stop when certain pre-defined conditions of the simulation have been reached.

In case the designer changes object 100 (for example, in the external appearance, in the material etc.), simulation computer 300 repeats the simulation for updated object-descriptive data <OBJECT>.

As using modified weighted quadrature in comparison to traditional quadrature speeds up processing (by making $S\_k$ relatively short for modified weighted quadrature), the description now discusses quadrature.

**Quadrature**

In sub-step 620 (that belongs to step 420), simulation computer 300 applies a quadrature routine. In comparison to traditional quadrature (cf. FIG. 4), the quadrature routine used is based on modified weighted quadrature (cf. FIG. 5). Simulation computer 300 thereby calculates the integral J by processing quadrature points and weights that computer 300 obtains by selecting them from a pre-defined set of points and weights (cf. step 610), cf. FIG. 5 with selected set 230 from collection 220.

With an example that will be explained with FIGS. 4 and 5, the description differentiates traditional quadrature (e.g., Gauss-Legendre quadrature, cf. FIG. 4), and modified weighted quadrature (cf. FIG. 5).

**Timing**

As the application of modified weighted quadrature is considered to speed up the processing, FIG. 2 also illustrates a convention regarding the time (on the right side): it should progress in top-down direction. As used herein, time indices and time attributes are index $k = 0$ for the attribute "initial", indices $k=1$ to $k = K-1$ for the attribute "intermediate", and index $k = K$ for the attribute "final".

The time is further differentiated into "real time", with acronyms $t\_0, t\_1, ..., t\_k, ... t\_K$ for time-points and $T\_k$ for time-steps or time-slots, related to the force application (in real-world, outside any computers, force-application time), and "simulation time", with acronym $S\_k$ for (duration of) the simulation sequence of steps 420/430, related to the operation of simulation computer 300.

Initial time-point $t\_0$ stands for the (real) time-point when F is not yet applied, intermediate time-points $t\_k$ stand for time-points when the object is being deformed (no matter if F is still being applied or not), and final time-point $t\_K$ stands for the time-point when deformation stops (e.g., because there would be no energy left over to deform this). The skilled person can apply other conventions.

Time-steps $T\_k$ can be defined as the time interval between $t\_k$ and $t\_k+1$. $T\_1$ is the initial time-step, and $T\_K-1$ is the final time-step. The figure illustrates $T\_k$.

Under applied force F, real-world object 100 would be expected to be converted from initial object 100.0 into final object 100.K. In general, this deformation can be regarded as a conversion process (of the object).

Simulation computer 300 executes method 400 (starting at step 610) for the first simulation sequence. It repeats steps 420/430 in consecutive simulation sequences $S\_k$ (until the final simulation sequence).

In view of shape data <SHAPE> to be predicted, there are two options to provide results:

- Simulation computer 300 can identify final shape 200.K only, as <SHAPE>.K. FIG. 2 shows simulation computer 300 as it renders final shape 200.K (on a display or the like, to simulation user 390).
- Or - in a more sophisticated simulation - simulation computer 300 can identify intermediate shapes 200.k as well (e.g., from $k = 1$ to $k = K-1$).

The description is simplified in assuming that one simulation sequence (i.e., steps 420/430 during $S\_k$) corresponds to one (real) time-step $T\_k$. Therefore, index k can be regarded as a counter for sequence execution. The skilled persons can choose K (number of time-steps $T\_k$, hence number of sequences) according to desired accuracy. It may be assumed that the time computer 300 needs for performing a single simulation sequence $S\_k$ is the same of all $k = 1$ to $k = K$.

However, the durations of time-steps $T\_k$ in the real-world and of sequence duration $S\_k$ as the time spend by simulation computer 300 are different. FIG. 2 symbolizes in top-down progress with sequence-slot $S\_k$ having larger duration than (real) time-step $T\_k$.

This symbolic illustration stands for a technical constraint: while a deformation in reality might take a couple of milli-seconds (or micro-seconds) in the real-world (overall time being the sum of $T\_1$ to $T\_K$), the simulation time by computer 300 may take a couple of hours, days, or even weeks (durations summed up, for $k = 1$ for $k = K$). This relatively large difference in the overall duration can become critical for the product manufacturer to answer the above questions (by real-world experiments, or by simulation).

Modified weighted quadrature (cf. FIG. 5) steps in here, by speeding up the simulation time. It is expected that the time required for a single simulation sequence ($S\_k$) is shorter for modified weighted quadrature, and longer for traditional quadrature.

**Force and objects**

To illustrate the force application F to object 100, FIG. 2 conveniently takes the physical contact between two real-world objects 100 and 105 (i.e., physical objects in reality) as an example. This illustration convention has been inspired by vehicle crash tests to walls (object 100 standing for the vehicle, object 105 standing for the wall).

<FORCE> data can represent initial conditions, such as a pre-contact velocity of object 100 moving to object 105, the direction of contact as in line 150 (cf. FIG. 2), and other data. The data can also identify assumptions regarding the second object (e.g., object 105 in FIG. 2 to be a non-flexible wall that keeps its shape). <FORCE> data also comprise boundary conditions, and connectivity constraints (e.g., the connection of different parts or components). The skilled person is able to consider <FORCE> in the TRIAL*TEST formulations.

As simulation computer 300 predicts the shape of object 100 by simulation, the force application is hypothetical. Force F is assumed to be applied to object 100. The symbolic illustration with force direction 150 being perpendicular to object 105 is just an example.

Other scenarios may have other deformations (and use other directions): For example, explosion experiments change the shape of the ammunition (e.g., object 100) and of the target (e.g., object 105).

It is therefore sufficient to discuss the prediction of at least one object (i.e., object 100), by simulation computer 300. In principle, both simulations (for both objects) could apply the modified weighted quadrature, but that is not required.

Shape 200 corresponds to object 100, and step 620 execution (modified weighted quadrature) is performed for shape 200. Repetitions (of simulation sequences 420/430) are performed from shape 200.k to shape 200.k+1.

As modified weighted quadrature comprises the identification of particular quadrature points (fewer points compared to traditional quadrature), savings in computation apply to simulation instances as well.

**Granularity**

It is noted that object 100 does not necessarily fit to the term "product" or "component". Object 100 can be a single-component product (such as in the hook example), object 100 can be a component (or sub-component) of a product (such as a vehicle). An example has already been explained with FIG. 1.

As used herein, object 100 has a dimension for that a single individual integral INTEGRAL_i = J TRIAL*TEST_i | $\Omega$ can be calculated by applying modified weighted quadrature in the spatial domain $\Omega$.

FIG. 3 illustrates an approach to represent shape 200 of object 100 (cf. FIG. 2) in the computer with basis functions (such as in simulation computer 300, cf. FIG. 2).

For simplicity, the figure leaves out the time index k, but in principle it is possible to represent shape 200.k and to calculate the individual integrals INTEGRAL_i = J TRIAL * TEST_i dx for any time between k = 0 and k = K, cf. FIG. 2.

As explained above with FIG. 2, property function f(x) represents a property of object 100 at object position 150. In shape 200, position 250 has already been introduced above, and FIG. 3 shows position 250 as well. In other words, f(x_#) is the property value that applies to position 250, and f(x) applies to shape 200 in general.

It is convenient that simulation computer 300 can show shape 200 to the product designer (i.e., to user 390 in FIG. 2), who can modify shape 200 (and hence object 100, if manufactured) by changing the control points, changing so-called knots, etc. Presenting shape 200 to the experts is convenient as well, but not required.

Simplified, the computer could draw shape 200 by setting parameter x to its start value a, by starting to draw shape 200 at control point P_0, by gradually increasing the parameter value and applying it to so-called basis functions. The computer would stop drawing when the parameter value x reaches its end value x = b.

However, showing shape 200 to users is not required but FIG. 3 but the principles of constructing shape 200 from sets of basis function is similar to using pre-defined and function-specific weights to perform modified weighted quadrature calculation.

Applying basis function implies selecting basis functions according to parameter values (for example, at knots), combining or superimposing basis functions and so on.

Applying quadrature is possible (traditional quadrature, or modified weighted quadrature) and the points and weights are mainly related to the basis functions.

In the example, object 100 can be an artefact made by wire that looks like the above-mentioned hook. The figure would be turned by 90 degrees clockwise. The hook is just an example for an object that can be described by a 2D cartesian coordinates system $(y^1, y^2)$ = (abscissa, ordinate).

In the example, it is also possible to consider object 100 to be bended foil in a 3D system $(y^1, y^2, y^3)$ for that the "hook shape" applies as well. For calculations, it might be sufficient to consider 2D only (because the foil would have a relatively small thickness, compared to other dimensions).

More in detail, FIG. 3 illustrates shape 200. Representing shapes by B-splines or other constructs with the help of basis functions B_i is known in the art. The example is simplified.

Instead of representing the shape by a collection of coordinate points, $(y^1, y^2)$ = {(0,0), (1,0.2), ... (2, -1)} (i.e., in physical space), the computer applies a so-called parameter space, with x being the parameter.

A mapping from a parameter space to the physical space (in coordinates) is available. A mapping function can be defined as

$$\{y\} = \{C\}\,(x), \text{ with } a \le x \le b.$$

The brackets { } here identify a vector in the dimension of the coordinate system. In other words, by changing parameter x from the start value x = a to the end value x = b, the 2D coordinates $\{y\} = (y^1, y^2)$ can be calculated. For convenience, the description uses examples with a = 0. The same principle applies for 3D as well.

Writing the mapping function as $\{y\} = \{C\}(x)$ is simplified, but some other conventions are required, among them the following:

- The type of the curve (i.e., shape 200) is predefined. In the example, the curve should be a so-called B-spline curve.
- Since the curve can be considered as a curve that shows a polynomial, the polynomial degree p is given as well. The degree p plays a role in defining the basis functions. The example uses the degree p = 3.

The description now explains further detail.

In the diagram plot of FIG. 3, the coordinate system with the $(y^1, y^2)$ coordinates has the value range [0,5] for $y^1$; and value range [-2,2] for $y^2$.

In that diagram plot of FIG. 3, control points P_0, P_1, P_2, P_3, P_4, P_5 and P_6 are illustrated by small squares. In general, the control points can be identified by indices "index" as control points P_index, with the index going from 0 to m. The control points P_index have $(y^1, y^2)$ coordinates.

For example, control point P_0 has coordinates (0,0), control point P_1 has coordinates (2,0), control point P_2 has coordinates (2,2), control point P_3 has coordinates (4, 2), control point P_4 has coordinates (5, 0), control point P_5 has coordinates (3,-2), and control point P_6 has coordinates (2, -1).

The arrangement of the control points (with straight lines between them) is a rough approximation of shape 200. It is noted that shape 200 belongs to the area that is spanned by the control points (i.e., representation is convex hull property). Further, the $(y^1, y^2)$ coordinates of the first control point (i.e., P_0) and of the last control point (i.e., P_6) are also the coordinates of shape 200. In other words, the curve starts at P_0 and ends at P_6.

As mentioned, the curve (shape 200) can be considered to comprise polynomials, this does not mean that the polynomials are the same everywhere. Designing objects (for example by the above-mentioned product designers) allows the freedom to vary the degree.

Some values - the so-called knot values x_knot-index of the parameter x, can be regarded as parameter values that define changes in the polynomials (such as the polynomial degree). In the diagram plot of FIG. 3, the points in shape 200 that correspond to knot values x_knot-index are identified as knots K1, K2 and K3.

In other words, the above-mentioned mapping function $\{y\} = \{C\}(x)$ is different for different value sub-ranges of x. From a different perspective, when the computer applies this mapping function, the computer starts with x = a, applies a first mapping function until parameter x reaches an intermediate value. The computer thereby identifies the coordinates of a first shape element. The computer then continues by a applying a second mapping function for the second shape element, and so on.

Shape 200 can also be called "patch", and in the example, the patch has the following shape elements: a first shape element (i.e., element 200@1) from control point P_0 to knot K1, a second shape element (i.e., element 200@2) from knot K1 to knot K2, a third shape element (i.e., element 200@3) from knot K2 to K3, a fourth shape element (i.e., element 200@4) from K3 to P_6.

It is noted that the control points are defined by coordinates, and that the knots are defined by parameter values. The shape elements can also be considered as polynomial pieces (to provide curvature continuity, in contrast to the straight lines between the control points).

The description now discusses the mapping function (i.e., the property function) with more detail.

While $\{y\} = \{C\}(x)$ gives just an overview, shape 200 can be described by the following shape function as well:

$$\{C\}(x) = \Sigma\ P\_index * B\_h\_p\,(x)$$

The sum goes from index = 0 to i = m - 1, with integer m standing for the number of control points. In the example of FIG. 3, there are m = 7 control points.

The formula for $\{C\}(x)$ is in vector notation (here to calculate coordinates $y^1$ and $y^2$) and in the example, parameter x is a one-dimensional parameter.

B_h_p(x) stands for so-called basis function in general notation. Index h is the basis function index. (The above-discussion differentiated basis functions for different uses, with different indices: trial functions with trial identifier j, and test functions with identifier i). Index p indicates the degree. In the example of FIG. 3 p = 3, the curve is a cubic curve. The description occasionally simplifies the notation of the basis functions, by leaving out p (as in the above formulas with B_j(x) and B_i(x). However, to calculate individual function values, p has to be considered.

Basis functions B_h_p(x) can be defined, for example, by a recursive calculation as follows:

B_i_0 (x) = 1 for x_h ≤ x <_ x_h+1 or B_i_0 (x) = 0 otherwise.

For p = 1, 2, 3 and so on, B_i_p(x) is defined by:

$$N\_i\_p(x)$$

$$= \quad (x - x\_h) \qquad / \qquad (x\_h+p - x\_h) \qquad * B\_h\_p\text{-}1(x)$$

$$+$$

$$(x\_h+p+1 - x) \qquad / \qquad (x\_h+p+1 - x\_h+1) \qquad * B\_h+1\_p\text{-}1(x)$$

By convention, the division 0/0 should be 0.

The formula goes back to works by Carl R. de Boor and M.G. Cox. It found its way into text-books. It is also know as "Cox-de Boor formula", "de Boor's algorithm" etc.. It is however noted, that basis functions represent polynomials, and that other formulas can be applied.

In other words, knowing i, p as well as the parameter range (between the start at x = a, and end at x = b) allows to calculate the values of the basis functions, for any parameter value x. Or, in other words, for any x (in the range), the values for the basis function can be calculated, and - for known control points - the coordinates could be calculated as well.

For shape 200 in FIG. 3 (i.e., with p = 3 and with m = 7), the basis functions are B_0_3 (x), B_1_3 (x), B_2_3 (x), B_3_3 (x), B_4_3 (x), B_5_3 (x), and B_6_3 (x).

It is again noted that p = 3 can be omitted from notation, so that the basis functions would be identified as B_0 (x), B_1 (x), B_2 (x), B_3 (x), B_4 (x), B_5 (x), and B_6 (x).

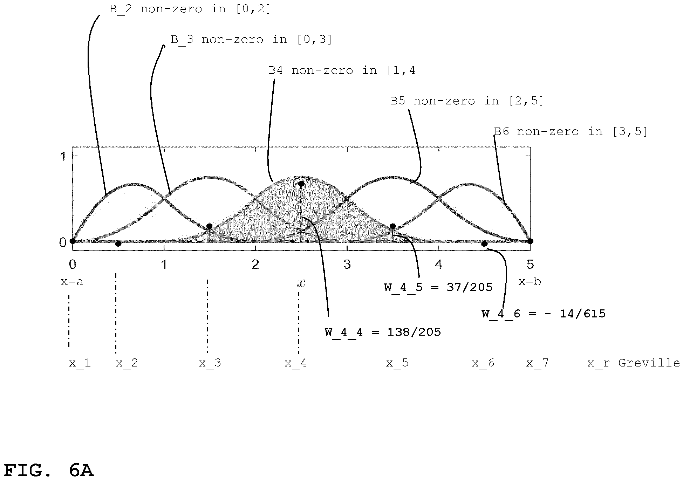

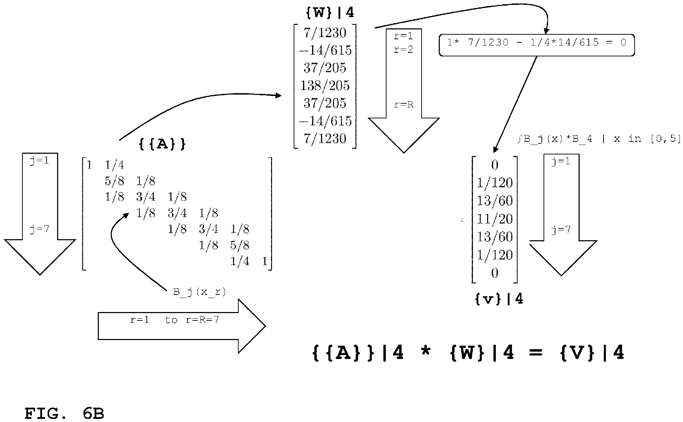

These basis function can serve as TRIAL and can serve as TEST, and the weight matrix {{W}} can be calculated accordingly, cf. FIGS. 6A and 6B.

**Calculating integrals**

FIGS. 4 and 5 illustrate the calculation of integrals J. FIG. 4 shows a typical setting (either analytically or with traditional quadrature), and FIG. 5 shows an approach with modified weighted quadrature.

Between the "J" symbol and the "dx" symbol, the integrand is defined as the multiplication (i.e., the product) of two functions:

- the trial function (TRIAL), and
- the test function (TEST).

Persons with skilled in the above-mentioned finite element analysis (FEA) are familiar with such an approach, to have TRIAL * TEST.

The terms TRIAL and TEST stand for the purpose, and the implementations can be along the following. The description now gives a very short example, for a calculation with the property function f(x) as the trial function, and an individual basis function B_i(x) as the test function (i.e., the "individual test basis function" or "test function" in short).

As the individual basis functions B_i(x) - for the purpose as test function - are different for different i, the integral is noted as "INTEGRAL _i" and the index i is called the "test identifier".

$$INTEGRAL\_i = \int f(x) * B\_i(x)\, dx \mid x \text{ in } [a, b]$$

**(formula 1)**

Multiple integrals are to be integrated, and every calculation requires the computer to spend resources. For convenience, the number of integrals (to be calculated) can be noted by uppercase "I" (the number of individual test functions).

For simplicity of explanation, the description occasionally takes test identifier i = 4 as an example so that it shows by way of example how INTEGRAL_4 is being calculated. For the other integrals (i.e., i = 1, i = 2 and so on), the calculations are performed likewise.

For simplicity of explanation, the spatial domain $\Omega$ is presented here by the parameter range x in [a, b].

To give some background regarding the property function f(x), that serves as the trial function, FIGS. 4 and 5 show shape 200 in an example with a curve. The curve symbolizes that object 100 could be a wire (such as a circular wire), could be a foil in side-view, and may be described by B-splines or NURBS in the context of isogeometric analysis (mentioned above) (cf. FIGS. 7A and 7B for a further example).

Properties at shape positions 250 are described by property function f(x), with x being the parameter in the parameter range x in [a, b], i.e., between a start parameter value at x = a and an end parameter value at x = b. The shape has been explained with FIG. 3, and an exemplary property could be the thickness (i.e., the diameter of the wire, thickness of the foil etc.), could be the physical weight (or mass) per position, or other properties.

For example, the skilled person knows that the volume of such an object can be calculated as the integral of its cross-sectional area (i.e., $\pi$*radius$^2$) over its length. The length can be derived from formulas that allow the calculation of the positions (in terms of coordinates, or in terms of parameters).

Property function f(x) may vary over parameter x so that, for example, the diameter changes. For simplicity it is assumed here that the property function f(x) is constant.

As mentioned, assuming the parameter x to have one dimension only is a simplification for simplicity, the skilled person is familiar with using multi-dimensional parameters, such as $(x^1, x^2, x^3)$ and multi-dimensional integrals.

### Analytical approach

As in formula (1) of FIG. 4, INTEGRAL_i = J f(x) * B_i(x) dx | x in [a, b] would be calculated if an analytical solution would be available. However, such solutions are rarely available.

### Convention

In the following, the above-mentioned number N of quadrature points (and weights) is discussed again, but the letter changes to Q and to R.

### Traditional quadrature

A quadrature rule is a numerical approximation to a definite integral of a function (i.e., the expression for the integrand between the "J" symbol and "dx" notation, here being TRIAL*TEST), usually in terms of a weighted linear combination of function evaluations at specified points in the spatial domain of integration (such as, for example, x in [a, b], or $\Omega$). The function TRIAL * TEST is typically a piecewise polynomial function (in scenarios of FIG. 2 that is usually the case) or is approximated by one function. Traditional approaches such as Gauss-Legendre quadrature have already been mentioned.

Multiple integrals are to be calculated for multiple test functions (that are identified by the test identifier i)

In formula (2) of FIG. 4, INTEGRAL_i = ∫ f(x) * B_i(x) dx | x in [a, b] would be calculated by a quadrature approximation as

$$
\begin{aligned}
\text{INTEGRAL\_i} \quad &= \quad \Sigma \text{ W\_q*f(x\_q) * B\_i(x\_q)} \qquad | \text{ q = 1 to q = Q} \\
&= \quad \text{W\_1*f(x\_1) * B\_i(x\_1)} \\
&\quad \ldots \\
&+ \quad \text{W\_q*f(x\_q) * B\_i(x\_q)} \\
&\quad \ldots \\
&+ \quad \text{W\_Q*f(x\_Q)*B\_i(x\_Q).}
\end{aligned}
$$

### (formula 2)

The integral "INTEGRAL_i" would remain specific to the test identifier i, and there would be I integrals to be calculated.

Index q = 1 to q = Q is the index for the quadrature weights W_q (that are not specific to i, but that are different for different q).

However, the number of weights would be Q, and the number of multiplications (and summations) would be accordingly.

In other words, the weights can be considered as a weight vector $\{W\} \mid Q$. The notation $\mid Q$ is merely an indication to use traditional quadrature.

The computational resources (per INTEGRAL_i) would correspond to the number of elements Q in the weight vector $\{W\} \mid Q$.

**Modified weighted quadrature**

In formula (3) that is shown in FIG. 5, the INTEGRAL_i = J f(x) * B_i(x) dx | x in [a, b] would be calculated by a quadrature approximation as

$$\text{INTEGRAL\_i} \quad = \quad \Sigma\, f(x\_r)*W\_i\_r \qquad\qquad \mid r = 1 \text{ to } r = R$$

$$= \quad f(x\_1) * W\_i\_1$$

$$\dots$$

$$+ \quad f(x\_r) * W\_i\_r$$

$$\dots$$

$$+ \quad f(x\_R) * W\_i\_R.$$

**(formula 3)**

In this case, r = 1 to r = R is the index for the quadrature weights for modified weighted quadrature. As the first glance, the formula looks quite similar as for traditional quadrature, but there are a couple of notable differences:

- The test function B_i(x_r) - that is evaluated at the quadrature point x_r is incorporated into the quadrature weight W_i_r. The weights do not have to be computed in real-time i.e., during the execution if method 400, and that is considered an advantage. The weights are specific to the test function (i.e., to index i). The description will provide an example with i = 4 (cf. FIG. 6A and 4B).
- The quadrature points x_r (in FIG. 5) are different from the quadrature points x_q (in FIG. 4).
- For an object with the same mesh (as in FIG. 4), fewer evaluations (i.e., calculations) are required: R << Q.

The weights can be also considered as a weight matrix $\{\{W\}\}$, with I weight vectors $\{W\}|i$. (The number of weight vectors here corresponds to the number of integrals to be calculated as test functions). The I quadrature calculations each use the same number of quadrature points and weights, namely R.

Having fewer quadrature points and weights is an advantage, because fewer calculations would have to be performed. It is desired to save computation, the figures merely symbolize the saving by showing many * symbols for traditional quadrature but only a few * symbols for modified weighted quadrature.

Regarding the selection of the quadrature points, i.e. the parameter values x_r, the parameter set $\{x\_r\} = \{x\_1, ..., x\_r, ... x\_R\}$ corresponds to interpolation points of the B-spline trial functions $\{B\_r(x)\} = \{B\_1(x), ... , B\_r(x), ..., B\_R(x)\}$. Each point x_r can be uniquely associated with a B-spline trial function B_r such that B_r(x_r) > 0.

Interpolation points can be the Greville points (also called Greville abscissae) or the Chebyshev-Demko points, as explained, for example, by Carl De Boor. "A practical guide to splines" Applied Mathematical Sciences, Vol. 27. New York: Springer-Verlag, 1978. The description herein takes the Greville points by way of example.

Simulation computer 300 obtains x_r by applying by pre-defined program routines that are known in the art and usually implemented in computer-aided design (CAD) software. The description follows up below with an example (cf. FIG. 6A).

**Validity of the weights**

The skilled person would expect that reducing the number of multiplications (by reducing the number of weights and reducing the number of quadrature points within [a, b]) would lead to a loss in accuracy (in the sense that $\Sigma$ is an approximation of J). However, this is not the case here. It is possible to calculate the weights (of course before calculating the $\Sigma$) and to prove that the calculated weights do not lead to a loss in accuracy.

As mentioned, the weights are specific to i, but the approach to calculate them is not specific to i. The description therefore leaves out the index i (by setting i = 4), at least here in the section.

The description continues with an example (cf. FIGS. 6A, 6B) in that the test identifier is i = 4:

$$\text{INTEGRAL\_4} \quad = \quad \Sigma\ f(x\_r)*W\_4\_r \qquad\qquad |\ r = 1\ to\ r = R$$

$$= \quad f(x\_1) * W\_4\_1$$

$$...$$

$$+ \quad f(x\_r) * W\_4\_r$$

$$...$$

$$+ \quad f(x\_R) * W\_4\_R.$$

### (formula 4)

In the notation with ∫, INTEGRAL_4 would be ∫ f(x) * B_4(x) dx | x in [a, b]

It is possible to apply the approaches (1) or (2) of FIG. 4 to calculate integrals (or sums), and then to obtain the weights.

FIGS. 6A and 6B illustrate a calculation that results in quadrature weights for the modified weighted quadrature. The weights comply with certain exactness conditions. FIG. 6A illustrates basis functions B_index(x) over [a, b] and FIG. 6B illustrates a matric calculation.

The notation B_index(x) is general and allows calculating them. In the example of FIGS. 6A and 6B, both TRIAL and TEST use basis functions, the index is noted as j for TRIAL and noted as i for TEST.

The values range [a, b] in this example is [0, 5], and the range has a uniform partition (0, 1, 2, 3, 4, 5), cf. the values on the abscissa in FIG. 6A. Quadratic B-splines (i.e., polynomial degree p = 2) serve as trial function and as test function (cf. TRIAL * TEST). The figures are limited to INTEGRAL_j_4 (i.e., i = 4 referring to test B_4 and j in 1...7 referring to trial function B_j). This is just a sample that is convenient for explanation. The partition does not have to be uniform and does not need not run within [0,5].

In other words, the integrals in this example would be

$$\text{INTEGRAL\_j\_4} = \int B\_j(x) * B\_4(x)\ dx\ |\ j = 1\ to\ 7,\ x\ in\ [0, 5]$$

### (formula 5)

Index j here stands for the number of J = 7 basis functions that in combination define the Quadratic B-spline trial functions in that partition (0, 1, 2, 3, 4, 5).

By simply combining formulas (for INTEGRAL_4 in the example), the Σ and ∫ notation leads to:

$$\Sigma\ B\_j(x\_r) * W\_4\_r = \int B\_j(x) * B\_4(x)\ dx$$

| ∫ separately to be calculated j = 1 to j =7, x in [0, 5]
| Σ for r = 1 to 7 as well (the number of weights corresponds to the number of the basis functions)

This formula (6) plays a role in calculating the weights to be explained here with FIGS. 6A and 6B, and formula (10), but the description starts to explain how to obtain the values x_r.

The Greville points (i.e., the example for the interpolation points) are shown as the projections of the black circle symbols to the x-axis). They are calculated as: 0.0 (i.e., x_1 in more general notation, with index r), 0.5 (i.e., x_2, FIG. 6A shows the x_2 as the reference, by way of example), 1.5 (i.e., x_3), 2.5 (i.e., x_4), 3.5 (i.e., x_5), 4.5 (i.e., x_6), 5.0 (i.e., x_7)

The number of interpolation points is R = 7, the same as the number of basis functions.

The 7 basis functions are non-zero in the following sub-ranges: B_1 in [0, 1] (function B1 is not illustrated), B_2 in [0, 2], B_3 in [0, 3], B_4 in [1, 4], B_5 in [2, 5], B_6 in [3, 5], and B_7 in [4, 5] (function B_7 is not illustrated).

The INTEGRAL_j_4 = J B_j(x) * B_4(x) dx | j = 1 to 7 would be written in Σ modified weighted quadrature as follows:

$$\Sigma \quad = \quad B\_j(x\_1) * W\_4\_1)$$
$$+ \quad B\_j(x\_2) * W\_4\_2)$$
$$+ \quad B\_j(x\_3) * W\_4\_3)$$
$$+ \quad B\_j(x\_4) * W\_4\_4)$$
$$+ \quad B\_j(x\_5) * W\_4\_5)$$
$$+ \quad B\_j(x\_6) * W\_4\_6)$$
$$+ \quad B\_j(x\_7) * W\_4\_7)$$

**(formula 7)**

The weight vector {W}4 for i = 4 would be {W 4_1, W_4_2, W_4_3, W_4_4, W_4_5, W_4_6, W_4_7}. The weights are not yet known, but the description explains with FIG. 6B how the weights can be obtained.

Taking the known values for x_r (i.e., in the example, the interpolation at the Greville points) into account, the following applies:

$$\Sigma \quad = \quad B\_j(0.0) * W\_4\_1$$
$$+ \quad B\_j(0.5) * W\_4\_2$$
$$+ \quad B\_j(1.5) * W\_4\_3$$
$$+ \quad B\_j(2.5) * W\_4\_4$$
$$+ \quad B\_j(3.5) * W\_4\_5$$
$$+ \quad B\_j(4.5) * W\_4\_6$$
$$+ \quad B\_j(5.0) * W\_4\_7$$

**(formula 8)**

The weights are still not known, but the following allows calculating them.

The solution to INTEGRAL_j_4 = J B_j(x) * B_4(x) dx | j = 1 to 7 (j being the trial identifier), x in [0, 5] can be written as vector {v_j} (with j being the trial identifier from j = 1 to j = 7). The solution can be calculated by simply calculating the integral analytically or using traditional quadrature. For the notation INTEGRAL_j_4, the following can be calculated:

$$\text{INTEGRAL\_1\_4} = \int B\_1(x) * B\_4(x) \, dx \mid x \text{ in } [0,5] \text{ leads to } V\_1 = 0.$$

$$\text{INTEGRAL\_2\_4} = \int B\_2(x) * B\_4(x) \, dx \mid x \text{ in } [0,5] \text{ leads to } V\_2 = 1/120.$$

$$\text{INTEGRAL\_3\_4} = \int B\_3(x) * B\_4(x) \, dx \mid x \text{ in } [0,5] \text{ leads to } V\_3 = 13/60.$$

$$\text{INTEGRAL\_4\_4} = \int B\_4(x) * B\_4(x) \, dx \mid x \text{ in } [0,5] \text{ leads to } V\_4 = 11/20.$$

$$\text{INTEGRAL\_5\_4} = \int B\_5(x) * B\_4(x) \, dx \mid x \text{ in } [0,5] \text{ leads to } V\_5 = 13/60.$$

$$\text{INTEGRAL\_6\_4} = \int B\_6(x) * B\_4(x) \, dx \mid x \text{ in } [0,5] \text{ leads to } V\_6 = 1/120.$$

$$\text{INTEGRAL\_7\_4} = \int B\_7(x) * B\_4(x) \, dx \mid x \text{ in } [0,5] \text{ leads to } V\_7 = 0.$$

**(formula 9)**

In this example, B_4 has the most overlap with itself, leading to 11/20, there is partial overlap between B_4 and B_3 and between B_4 and B_5 leading to 13/60 and so on. The functions B_1 and B_4 and the functions B_7 and B_4 do not overlap, so the integral is zero.

At the first glance, the skilled person would assume that some quadrature weights in traditional quadrature could be set to zero, because for some sub-ranges within [0, 5], same basis functions would not have support (i.e., $B\_i(x) = 0$). The multiplication with a parameter value $x\_q$ would remain zero.

However, the calculation is performed for integrals over the whole range [a, b] (here: [0, 5]) and not for individual sub-ranges. Consequently, the determination of the weights (i.e., $W\_i\_r$) results in weights (for $x\_r$) that are non-zero, even if a particular basis function would be zero at $x\_r$. The determination of the weights $W\_i\_r$ is based on an exactness condition.

**Matrix for the exactness condition**

Linear equation systems can be established, individually for i (i = 4 in the example), so calculate the i-specific weights

$$\{\{A\}\} * \{W\}|i = \{V\}|i$$

$$\{\{A\}\} * \{W\}|4 = \{V\}|4$$

## (formula 10)

The elements of matrix $\{\{A\}\}$ are computed from the 7 trial functions evaluated at the R = 7 Greville points. This matrix does not depend on the test identifier i.

Formula 10 corresponds to formula 6, along the following:

- $\{\{A\}\}$ is a matrix with R columns and R rows (i.e., corresponding to the number of weights in modified weighted quadrature). The notation |4 stands for the example in that i = 4: the individual INTEGRAL_i would be calculated for i = 4 (cf. the TEST-function is $B\_4$). The limitation to i = 4 is not a speed constraint because $\{\{A\}\}$ can be pre-calculated, prior to step 610 in FIG. 2).
- The elements of the matrix $\{\{A\}\}$ are the $B\_j (x\_r)$, with j for the rows and r for the columns.

Vector $\{V\}| 4$ (or $\{V\}| i$ in general) stands for J $B\_j(x) * B\_4(x)$ dx of equation (6), with j identifying the vector elements $V\_j$.

**Solving the system**

In the theory of splines (cf. the book by De Boor) matrix $\{\{A\}\}$ is known as a spline interpolation matrix. Such a matrix is square and is always invertible. Therefore, the solution vector $\{W\}|i$ (in the example $\{W\}|4$) is uniquely computable.

The time to solve the system is not critical for the performance, it can be solved prior to step 610 (cf. FIG. 2).

As the weights in vector $\{W\}|4$ fit to the linear equations, the integrals would be calculated exactly as possible. Deviations would only be caused by intrinsic calculation errors in the computer itself (e.g., $V\_7 = E^{-15}$ instead of 0). But such errors can be neglected.

Once the quadrature weights are determined via the formula (10), the modified weighted quadrature can be applied in the context of finite element analysis (FEA).

**Re-use**

Simulation computer 300 (cf. FIG. 2) can calculate $\{\{W\}\}$ in advance (cf. step selecting 610): Reference 220 stands for a collection of pre-defined sets with quadrature weights (i.e., $\{\{W\}\}$ for different configurations). Collection 220 can be calculated once and collection 220 can be re-used.

The weight sets are different according to descriptors 210, such as, for example, the number of $B\_h\_p$ basis functions per shape for different numbers of trial and test functions (cf. the example with 7, but there are other numbers as well), the polynomial degree p, and the range [a, b] and the quantization of the parameter x in that range.

Computer 300 selects a suitable weight set 230 accordingly and applies the weights $W\_i\_r$ of that selected set 230. Selected weights $W\_i\_1, ... W\_i\_r, ... W\_i\_R$ allow the calculation of the integral with the accuracy that corresponds to that of using the traditional quadrature.

Having selected set 230 and having determined the Greville points (i.e., the interpolation points in general), simulation computer 300 is able to apply the sigma formula (cf. formula (3) and to calculate the integrals.

As selecting the weights from pre-defined sets depends on the way a particular shape is represented by data, the description now turns to that topic:

## Object and shape

FIG. 7A illustrates object 100 that belongs - in various hierarchy stages - to product 1000. FIG. 7A also symbolizes modified weighted quadrature by showing object 100 in different views.

In the example, product 1000 is made of foils, and product 1000 can be manufactured by forming processes. It is possible to differentiate different product components, but FIG. 7A is simplified by showing object 100 that just belongs to product 1000 (cf. the perspective view above).

Simulation computer 300 (cf. FIG. 2) applies modified weighted quadrature to object 100 with quadrature points shows (black dot symbols) in the view from above and in the side-view. Product 1000 can have multiple objects, and the bold lines (100-E) that are drawn within product 1000 can be considered to (virtually) separate objects from each other. Of course, simulation computer 300 can apply modified weighted quadrature to other objects as well.

Object 100 has the geometry of a quadrilateral (i.e., four-sided polygon, having four edges 100-E1, 100-E2, 100-E3, 100-E4 and four corners. The edges may be curved.

Shape 200 of object 100 can be described by a B-spline (here shown as a curve in a coordinate system $(y^1, y^2)$) with extension in a direction that is orthogonal to $(y^1, y^2)$. In other words, in the view from above (in the figure below), shape 200 appears as a rectangle with edges 200-E1, 200-E2, 200-E3, and 200-E4 (corresponding to the edge of the object).

In side-view, shape 200 appears as a B-spline curve (for edges 200-E1 and 200-E3). Property function $f(x^1)$ with parameter $x^1$ is symbolized by the example of the thickness property. Parameter $x^1$ is the parameter for the curve.

In the view from above, property function $f(x^2)$ can be described by parameter $x^2$, in terms of coordinates, $x^2$ would correspond to $y^3$.

The dashed lines indicate that the definition of the B-spline curve may change, and this dashed line correspond to so-called knots (cf. FIG. 3 for details).

Regarding the quadrature, the above-introduced sigma formula would be expanded for two-dimensional parameters $(x^1, x^2)$. The skilled person is familiar with such an extension from one parameter dimension to multiple parameter dimensions. Where for a particular parameter (e.g., $x^1$, $x^2$ or $x^3$) the integral would have to be calculated (cf. formula 2), formula 3 for modified weighted quadrature would be used instead, otherwise the expansion would be the same.

FIG. 7A illustrates quadrature points $x\_r^1$ by small black dots. The number $R^1 = 5$ is a simplification, $R^1$ can be otherwise. The parameter range $[a^1, b^1]$ goes from $x^1 = a^1$ that points to a corner position (edges 200-E4 and 200-E3), to $x^1 = b^1$ that points to a corner position as well (edges 200-E3 and 200-E2). The subscript "1" is added to illustrate that the parameter belongs to a multidimensional parameter.

Quadrature points for $x\_r^2$ are omitted from illustration.

In terms of both parameters $x^1$ and $x^2$, together with basis functions (cf. FIG. 3), they define positions on object 100 (and on shape 200, cf. the $\Omega$ notation) and therefore also allows to define the property function.

Traditionally, Gaussian quadrature would be applied element by element using p+1 points per element in each coordinate direction, where p is the polynomial degree of the trial basis functions. This leads to approximately Q = (p+1)*M points to edge 200-E3 (corner to knot, where the dashed line meets the edge), where M is the number of elements on edge 200-E3.

Modified weighted quadrature processes an integral defined over a set of elements of a B-spline patch (i.e. from a to b in the 1D example) in one go. In the example, the total number of quadrature points defined on edge 200-E3 is approximately R = M+p. Therefore, the number of calculations with R points is smaller than the number of calculations with Q points.

The benefit in reduction of the number of quadrature points used in modified weighted quadrature versus traditional Gaussian quadrature is more apparent for surface and volume integrals. FIG. 7B illustrates object 100 that belong to a cylinder. Object 100 is represented by the two-dimensional parameter tuple $(x^1, x^2)$. On its left side, FIG. 7B shows quadrature points $(x\_r^1, x\_r^2)$ for modified weighted quadrature (i.e., Greville points here in $x^1$ and $x^2$), and on its right side it shows quadrature points $(x\_q^1, x\_q^2)$ for traditional quadrature. There are fewer points for modified weighted quadrature.

## Object in 3D

Objects that can be described using a single coordinate are referred to as "curves". A curve may consist of one or more pieces (called a curve patch), see Figure 6. On each patch the property function can be defined via f(x) with the parameter range [a,b].

Objects that can be described by 2D parametric coordinates are also referred to as "surfaces" or "surface objects" (as in FIGS. 7A and 7B). Complex surfaces can be decomposed into a set of quadrilateral patches. On each patch the property functions can be defined accordingly as f($x^1$, $x^2$) and the parameter ranges as [$a^1$, $b^1$], [$a^2$, $b^2$].

Objects that require 3D parametric coordinates are also referred to as "solids" or "solid objects". Complex solids can be decomposed into cubical patches. On each patch the property functions can be defined accordingly as f($x^1$, $x^2$, $x^3$). The same principle applies to the parameter ranges [$a^1$, $b^1$], [$a^2$, $b^2$] [$a^3$, $b^3$].

Curve, quadrilateral or cubical patches may be further divided into smaller pieces, known as finite elements in the art, in which the property functions are described by single polynomials.

Traditional quadrature processes element by element, while modified weighted quadrature processes an entire patch in one go.

## Design process

FIG. 8 illustrates a flow chart of design process 500 with the process-performing entities CAD computer 350, simulation computer 300, and factory 370.

As illustrated by arrow 1, CAD computer 350 provides data that describes object 100: object-descriptive data (<OBJECT> data), with <SHAPE> data and {PROPERTY} data. Simulation computer 300 receives <OBJECT> data.

As the process is a design process, object 100 is not yet physically available.

Simulation computer 300 also receives data that represent the force application, in short <FORCE> data. Simulation computer 300 does not have to receive <FORCE> from CAD computer 350. But it may receive <FORCE> from libraries that describe standardized test environments.

The skilled person is familiar with considering data <OBJECT> and <FORCE>. Having received <OBJECT> data and <FORCE> data, simulation computer 300 performs computer-implemented method 400 to simulate a shape change of object 100. Method 400 comprises the following steps (in repetitions):

- In step 610, simulation computer 300 obtains quadrature weights W_r by selecting a particular set 230 of quadrature weights from a plurality of pre-defined sets 220 (cf. FIG. 5).
- In step 420, simulation computer 300 processes <OBJECT> data and <FORCE> data. Step 420 comprises step 620. As mentioned, step 420 can comprise assembling and solving a matrix (known to the skilled person).
- In step 430, simulation computer 300 optionally updates the shape data, <SHAPE>.k is updated by <SHAPE>.k+1.

Steps 420 and 430 (simulation sequence) are repeated for substantially all k (to k = K) in a simulation instance. As the result of step 430 (update) is input for step 420 (i.e., <OBJECT> is updated, <FORCE> substantially remains unchanged).

Conditions to stop repetitions are in the expertise of the skilled person.

Performing steps 420 and 430 is substantially a serial sequence that can not be performed in parallel.

FIG. 8 illustrates that step 620 could be performed for multiple objects separately, thus in parallel. But parallel execution does not solve the problem that quadrature needs a certain number of weights.

Computer 200 performs method 400 and would provide the final shape 200.K as the simulation result (i.e., as <SHAPE>.K, in step 440). In the example of a crash to be simulated, shape 200.K would correspond to a post-crash geometry (cf. 200.K in FIG. 2).

As illustrated by arrow 2, process 500 continues by handing over the simulation result to CAD computer 350 (or rather to its user, for example, the product designer).

CAD computer 350 may provide updated object data <OBJECT>, cf. dashed arrow 3. The update in <OBJECT> data can be in <SHAPE> data, e.g., making the object larger) or in {PROPERTY} data, e.g., selecting a different material. Simulation computer 300 repeats method 400 with updated <OBJECT> data and with original <FORCE> data. Other repetitions of method 400 are possible as well.

With or without repeating method 400, arrow 4 symbolizes that simulation computer 300 eventually finished the simulation with a result that allows factory 370 to produce object 100. Object 100 and optionally other objects 100' (to the designed likewise) belong to product 1000.

Design process 500 is illustrated and described here with much simplification, and the skilled person is able to implement step sequences with assembling the matrix, solving the matrix, and updating the shape.

## Problems

FIG. 8 is also convenient to discuss problems and solutions approaches. As illustrated by arrow 1 and 3, object-descriptive data <OBJECT> is provided by CAD computer 350 and is received (and processed in method 400) by simulation computer 300. Representing the shape by so-called B-splines (and other isogeometric conventions) allows a transfer (to computer 300) without significantly modifying the data.

Steps 410, 420 and 430 each require computer 300 to use memory and processing resources, and the major share of resource consumption is in step 620.

The above-mentioned granularity in space does matter: simplified, increasing the spatial granularity in object data <OBJECT> - especially to describe shape 200 - increases the demand for resources. {PROPERTY} data is of less concern. For example, the material of the object is the same no matter how detailed its shape is being represented.

As mentioned above, calculations involve the estimation of integrals and using quadrature routines requires calculations (such as floating point operations in the CPU or GPU of the computer). The calculations consume computation resources. Just skipping some quadrature points would be incompatible with accuracy.

However, modified weighted quadrature allows to calculate quadrature weights in advance and to reduce the overall number of quadrature points (cf. $R << Q$, FIG. 5). Consequently, the number of calculations (and hence the consumption of processing time) can be reduced.

**GPU**

Applying modified weighted quadrature routines (in step 620, cf. FIGS. 2 and 8) involves floating points operations in the processors of simulation computer 300.

Modern computers have multiple processing units, and heterogeneous arrangements with one or more central processing units (CPU) and one or more graphics processing units (GPU) are common. The skilled person can implement method 400 such that step 620 is performed by the GPU. Further, for products that comprise multiple components (and sub-components), step 620 can be performed in parallel for different objects (that correspond to (sub) components).

There is no need to adapt the processors, and although GPUs had originally been developed for graphics processing, the underlying floating point operations (and other operations) are available in the instruction set of these processors.

**Generic computer**

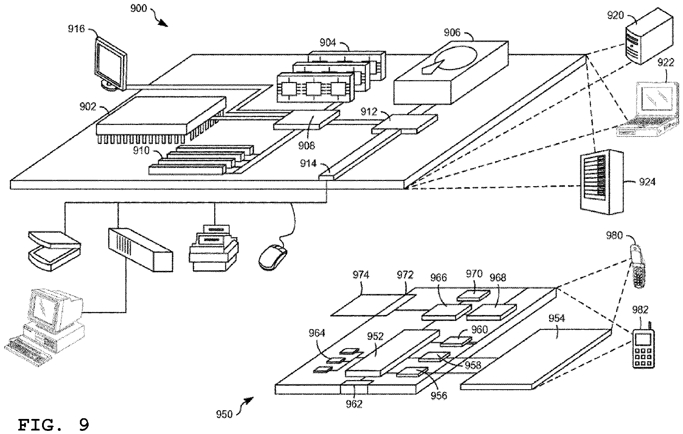

FIG. 9 illustrates an example of a generic computer device which may be used with the techniques described here. FIG. 9 is a diagram that shows an example of a generic computer device 900 and a generic mobile computer device 950, which may be used with the techniques described here. Computing device 900 is intended to represent various forms of digital computers, such as laptops, desktops, workstations, personal digital assistants, servers, blade servers, mainframes, and other appropriate computers. Generic computer device may 900 correspond to the computers that have been illustrated by other figures. Computing device 950 is also intended to represent various forms of mobile devices, such as personal digital assistants, cellular telephones, smart phones, driving assistance systems or board computers of vehicles and other similar computing devices. For example, computing device 950 may be used as a frontend by a user to interact with the computing device 900. The components shown here, their connections and relationships, and their functions, are meant to be exemplary only, and are not meant to limit implementations of the inventions described and/or claimed in this document.

Computing device 900 includes a processor 902, memory 904, a storage device 906, a high-speed interface 908 connecting to memory 904 and high-speed expansion ports 910, and a low speed interface 912 connecting to low speed bus 914 and storage device 906. Each of the components 902, 904, 906, 908, 910, and 912, are interconnected using various busses, and may be mounted on a common motherboard or in other manners as appropriate. The processor 902 can process instructions for execution within the computing device 900, including instructions stored in the memory 904 or on the storage device 906 to display graphical information for a GUI on an external input/output device, such as display 916 coupled to high speed interface 908. In other implementations, multiple processors and/or multiple buses may be used, as appropriate, along with multiple memories and types of memory. Also, multiple computing devices 900 may be connected, with each device providing portions of the necessary operations (e.g., as a server bank, a group of blade servers, or a multi-processor system).

The memory 904 stores information within the computing device 900. In one implementation, the memory 904 is a volatile memory unit or units. In another implementation, the memory 904 is a non-volatile memory unit or units. The memory 904 may also be another form of computer-readable medium, such as a magnetic or optical disk.

The storage device 906 is capable of providing mass storage for the computing device 900. In one implementation, the storage device 906 may be or contain a computer-readable medium, such as a floppy disk device, a hard disk device, an optical disk device, or a tape device, a flash memory or other similar solid state memory device, or an array of devices, including devices in a storage area network or other configurations. A computer program product can be tangibly embodied in an information carrier. The computer program product may also contain instructions that, when executed, causes the computer to perform one or more methods, such as those described above. The information carrier is a computer- or machine-readable medium, such as the memory 904, the storage device 906, or memory on processor 902.

The high speed controller 908 manages bandwidth-intensive operations for the computing device 900, while the low speed controller 912 manages lower bandwidth-intensive operations. Such allocation of functions is exemplary only. In one implementation, the high-speed controller 908 is coupled to memory 904, display 916 (e.g., through a graphics processor or accelerator), and to high-speed expansion ports 910, which may accept various expansion cards (not shown). In the implementation, low-speed controller 912 is coupled to storage device 906 and low-speed expansion port 914. The low-speed expansion port, which may include various communication ports (e.g., USB, Bluetooth, Ethernet, wireless Ethernet) may be coupled to one or more input/output devices, such as a keyboard, a pointing device, a scanner, or a networking device such as a switch or router, e.g., through a network adapter.

The computing device 900 may be implemented in a number of different forms, as shown in the figure. For example, it may be implemented as a standard server 920, or multiple times in a group of such servers. It may also be implemented as part of a rack server system 924. In addition, it may be implemented in a personal computer such as a laptop computer 922. Alternatively, components from computing device 900 may be combined with other components in a mobile device (not shown), such as device 950. Each of such devices may contain one or more of computing device 900, 950, and an entire system may be made up of multiple computing devices 900, 950 communicating with each other.

Computing device 950 includes a processor 952, memory 964, an input/output device such as a display 954, a communication interface 966, and a transceiver 968, among other components. The device 950 may also be provided with a storage device, such as a microdrive or other device, to provide additional storage. Each of the components 950, 952, 964, 954, 966, and 968, are interconnected using various buses, and several of the components may be mounted on a common motherboard or in other manners as appropriate.

The processor 952 can execute instructions within the computing device 950, including instructions stored in the memory 964. The processor may be implemented as a chipset of chips that include separate and multiple analog and digital processors. The processor may provide, for example, for coordination of the other components of the device 950, such as control of user interfaces, applications run by device 950, and wireless communication by device 950.

Processor 952 may communicate with a user through control interface 958 and display interface 956 coupled to a display 954. The display 954 may be, for example, a TFT LCD (Thin-Film-Transistor Liquid Crystal Display) or an OLED (Organic Light Emitting Diode) display, or other appropriate display technology. The display interface 956 may comprise appropriate circuitry for driving the display 954 to present graphical and other information to a user. The control interface 958 may receive commands from a user and convert them for submission to the processor 952. In addition, an external interface 962 may be provide in communication with processor 952, so as to enable near area communication of device 950 with other devices. External interface 962 may provide, for example, for wired communication in some implementations, or for wireless communication in other implementations, and multiple interfaces may also be used.

The memory 964 stores information within the computing device 950. The memory 964 can be implemented as one or more of a computer-readable medium or media, a volatile memory unit or units, or a non-volatile memory unit or units. Expansion memory 984 may also be provided and connected to device 950 through expansion interface 982, which may include, for example, a SIMM (Single In Line Memory Module) card interface. Such expansion memory 984 may provide extra storage space for device 950, or may also store applications or other information for device 950. Specifically, expansion memory 984 may include instructions to carry out or supplement the processes described above, and may include secure information also. Thus, for example, expansion memory 984 may act as a security module for device 950, and may be programmed with instructions that permit secure use of device 950. In addition, secure applications may be provided via the SIMM cards, along with additional information, such as placing the identifying information on the SIMM card in a non-hackable manner.

The memory may include, for example, flash memory and/or NVRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 964, expansion memory 984, or memory on processor 952 that may be received, for example, over transceiver 968 or external interface 962.

Device 950 may communicate wirelessly through communication interface 966, which may include digital signal processing circuitry where necessary. Communication interface 966 may provide for communications under various modes or protocols, such as GSM voice calls, SMS, EMS, or MMS messaging, CDMA, TDMA, PDC, WCDMA, CDMA2000, or GPRS, among others. Such communication may occur, for example, through radio-frequency transceiver 968. In addition, short-range communication may occur, such as using a Bluetooth, WiFi, or other such transceiver (not shown). In addition, GPS (Global Positioning System) receiver module 980 may provide additional navigation- and location-related wireless data to device 950, which may be used as appropriate by applications running on device 950.

Device 950 may also communicate audibly using audio codec 960, which may receive spoken information from a user and convert it to usable digital information. Audio codec 960 may likewise generate audible sound for a user, such as through a speaker, e.g., in a handset of device 950. Such sound may include sound from voice telephone calls, may include recorded sound (e.g., voice messages, music files, etc.) and may also include sound generated by applications operating on device 950.

The computing device 950 may be implemented in a number of different forms, as shown in the figure. For example, it may be implemented as a cellular telephone 980. It may also be implemented as part of a smart phone 982, personal digital assistant, or other similar mobile device.

Various implementations of the systems and techniques described here can be realized in digital electronic circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" and "computer-readable medium" refer to any computer program product, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

To provide for interaction with a user, the systems and techniques described here can be implemented on a computer having a display device (e.g., a CRT (cathode ray tube) or LCD (liquid crystal display) monitor) for displaying information to the user and a keyboard and a pointing device (e.g., a mouse or a trackball) by which the user can provide input to the computer. Other kinds of devices can be used to provide for interaction with a user as well; for example, feedback provided to the user can be any form of sensory feedback (e.g., visual feedback, auditory feedback, or tactile feedback); and input from the user can be received in any form, including acoustic, speech, or tactile input.

The systems and techniques described here can be implemented in a computing device that includes a back end component (e.g., as a data server), or that includes a middleware component (e.g., an application server), or that includes a front end component (e.g., a client computer having a graphical user interface or a Web browser through which a user can interact with an implementation of the systems and techniques described here), or any combination of such back end, middleware, or front end components. The components of the system can be interconnected by any form or medium of digital data communication (e.g., a communication network). Examples of communication networks include a local area network (LAN), a wide area network (WAN), and the Internet.

The computing device can include clients and servers. A client and server are generally remote from each other and typically interact through a communication network. The relationship of client and server arises by virtue of computer programs running on the respective computers and having a client-server relationship to each other.

A number of embodiments have been described. Nevertheless, it will be understood that various modifications may be made without departing from the spirit and scope of the invention.

In addition, the logic flows depicted in the figures do not require the particular order shown, or sequential order, to achieve desirable results. In addition, other steps may be provided, or steps may be eliminated, from the described flows, and other components may be added to, or removed from, the described systems. Accordingly, other embodiments are within the scope of the following claims.

**References**

| | |
|---|---|
| $\{\{A\}\}$ | matrix |
| $\{\{W\}\}$ | weight matrix |
| a, b | start and end parameter in parameter range |
| $B\_h\_p(x)$ | basis function in general |
| $B\_j(x)$, $B\_i(x)$ | basis function, in trial and in test |
| d | number of physical dimensions of the object |
| h | general index to define basis functions |
| i | test identifier, index for individual integrals to be calculated |
| I | number of integrals to be calculated |
| j | trial identifier |
| J | number of basis function in the trial function |
| k | time index |
| K | number of time-steps, number of simulation sequences |
| F | hypothetical force |
| f(x) | property function |
| m | number of control points |

| | |
|---|---|
| p | polynomial degree, spline order |
| q | quadrature point index, traditional quadrature |
| Q | number of products, traditional quadrature |
| r | quadrature point index, modified weighted quadrature |
| R | number of products, modified weighted quadrature |
| T_k | time-slots (real-world) |
| S_k | duration of a single simulation sequence |
| {W} | weight vector |
| W_q | weights (traditional approach) |
| W_r, {W}|i | weights (modified weighted approach) |
| x | parameter |
| x# | parameter x with arbitrary value, for illustration only |
| $y^1, y^2, y^3$ | coordinates |
| ∫ | integral |
| 100 | virtual division of real-world object |
| 101, 102, 103 | further real-world object |
| 105 | further real-world object |
| 150 | force direction |
| 200 | shape |
| 220 | weight set collection |
| 230 | selected weight set |
| 300 | simulation computer |
| 350 | CAD computer |
| 370 | factory |
| 390 | simulation user |
| 400, 4xx | method, steps |
| 610, 620 | steps for modified weighted quadrature |
| 9xx | generic computer, with components |
| 1000 | real-world object |

**Claims**

1. Computer-implemented method (400) to predict the shape (200.K) of a real-world object (100.K) as a result of hypothetical force application (F) to the real-world object (100), wherein the real-world object (100) is expected to be converted from an initial object (100.0) having an initial shape (200.0) into a final object (100.K) having a final shape (200.K), the method (400) being implemented by a simulation computer (300) that represents the shape (200) of the object (100) by basis functions with a parameter (x) in a parameter range ([a, b]) from a start parameter value (a) to an end parameter value (b), and that calculates (420) individual integrals (INTEGRAL_i) for individual basis functions (B_i)

$$\text{INTEGRAL\_i} \quad = \quad \int f(x) * B\_i(x)\, dx \mid x \text{ in } [a, b]$$

with the integrand being the product of

   • a property function (f(x)) that describes a property of the object (100) at positions (150, 250), as a trial function (TRIAL), and
   • an individual basis function (B_i(x)), as a test function (TEST),
   wherein the simulation computer (300) calculates (620) the individual integral (INTEGRAL_i) by applying quadrature,
   the method (400) **characterized in that** the simulation computer (300) calculates (620)
   the individual integrals (INTEGRAL_i) by applying quadrature according to

$$\Sigma\, f(x\_r) * W\_i\_r \quad \mid r = 1 \text{ to } r = R$$

being the sum of R products of

   • quadrature weights (W_i_r) that are specific to the individual basis function (B_i(x)) and that are specific to the parameter set (x_r) that corresponds to interpolation points of the individual basis function (B_i(x)) within the parameter range ([a, b]), and
• particular values of the property function (f(x_r)) at the quadrature points (x_r).

2. Method (400) according to claim 1, wherein the simulation computer (300) obtains the quadrature weights (W_i_r) that are specific to the individual basis function (B_i(x)) by selecting (610) the quadrature weights from pre-defined weight sets (220, 230).

3. Method (400) according to claim 2, wherein selecting (610) the quadrature weights from pre-defined weight sets (220, 230) comprises

• analyzing the property function (f(x)) to identify descriptors (210) of the property function (f(x)), and
• selecting the weight set (230) according to the descriptors (210).

4. Method (400) according to claim 3, wherein the descriptors (210) comprise:

• the polynomial degree (p) of the basis functions (B_i(x)) that in combination represents the shape (200) of the object (100), and
• indications of the applicability of particular basis functions (B_i(x)) for particular parameter sub-ranges of the parameter range ([a, b]).

5. Method (400) according to claim 5, wherein the simulation computer (300) determines the interpolation points (x_r) of the individual basis function (B_i(x)) within the parameter range ([a, b]) by evaluating the sub-intervals.

6. Method (400) according to claim 5, wherein the simulation computer (300) determines the interpolation points (x_r) that are Greville points or that are Chebyshev-Demko points.

7. Method (400) according to any of claims 4 to 6, wherein the simulation computer (300) receives the indication of the applicability of particular basis functions as a knot vector.

8. Method (400) according to any of claims 1 to 7, wherein the simulation computer (300) calculates (620) the integrals, starting with the initial shape (200.0), and wherein the simulation computer (300) uses the calculated integrals for further calculations that process data that describe the force application (F).

9. Method (400) according to any of claims 1 to 8, wherein the simulation computer (300) calculates (420) the individual integrals (INTEGRAL_i) as part of calculations with targets selected from the following: calculating the mass of the object (100) for further calculating the displacement of the object (100) due to the force application.

10. Method (400) according to any of claims 1 to 9, wherein the simulation computer (300) represents the shape (200) of the object (100) by the basis functions to represent the object (100) by B-splines or by NURBS.

11. Method (400) according to any of claims 1 to 10, wherein the simulation computer (300) applies the results of calculating the integrals to update the shape (200) from the initial shape (200.0), via intermediate shapes (200.k) to the final shape (200.K).

12. Use of the method (400) according to any of claims 1 to 11, in the design process (500) of the real-world object (100), wherein the simulation computer (300) receives the at least one shape representation (200) from a CAD computer (350).

13. Use of the method (400) according to any of claim 1 to 11, in the design process (500) of a multi-object product, wherein the simulation computer (300) performs the method (400) is parallel for multiple real-world objects (100) that belong to the multi-object product.

14. A computer program product that, when loaded into a memory of a computer system and executed by at least one processor of the computer system, causes the computer system to perform the steps of a computer-implemented method according to any of claims 1 to 11.

15. A computer system comprising a plurality of function modules which, when executed by the computer system, perform the steps of a computer-implemented method according to any of the claims 1 to 11.

(A)    (B)    (C)

F

1000

100    101

102    103

200

100

200

FIG. 1

FIG. 2

$$y^1 = C^1(x)$$
$$y^2 = C^2(x)$$

200

FIG. 3

position 250

x = b

200 shape

x = a

TRIAL* TEST

(1)  INTEGRAL_i = ∫ f(x)*B_i(x)dx | x = [a, b]

(2)  INTEGRAL_i = Σ W_q*f(x_q)*B_i(x_q)

= W_1*f(x_1)*B_i(x_1) +

{W}|Q
weight vector

W_q*f(x_q)*B_i(x_q) +

...                                    +

W_Q*f(x_Q)*B_i(x_Q)

= * * * * * * * * * * * * * * * *

**FIG. 4**          (Q operations)

250
f(x#)

200 shape

B_i_p
p                210
a, b             descriptors

selection criteria

230 (selected)

interpolation points
x_r

220

W-sets
{{W}}

(3) INTEGRAL_i = Σ  W_i_r*f(x_r)
            =    W_i_1*f(x_1)  +
                 W_i_r*f(x_r)  +
                 ...           +
                 W_i_R*f(x_R)

FIG. 5           =    *    *    *    *    *    *    *     (R<<Q)

B_2 non-zero in [0,2]

B_3 non-zero in [0,3]

B4 non-zero in [1,4]

B5 non-zero in [2,5]

B6 non-zero in [3,5]

W_4_5 = 37/205

x=a          x=b

W_4_6 = - 14/615

W_4_4 = 138/205

x_1    x_2        x_3        x_4          x_5        x_6    x_7    x_r Greville

FIG. 6A

{W}|4

$$\begin{bmatrix} 7/1230 \\ -14/615 \\ 37/205 \\ 138/205 \\ 37/205 \\ -14/615 \\ 7/1230 \end{bmatrix}$$

r=1
r=2

r=R

1* 7/1230 - 1/4*14/615 = 0

{{A}}

$$\begin{bmatrix} 1 & 1/4 \\ 5/8 & 1/8 \\ 1/8 & 3/4 & 1/8 \\ & 1/8 & 3/4 & 1/8 \\ & & 1/8 & 3/4 & 1/8 \\ & & & 1/8 & 5/8 \\ & & & & 1/4 & 1 \end{bmatrix}$$

j=1

j=7

∫B_j(x)*B_4 | x in [0,5]

$$\begin{bmatrix} 0 \\ 1/120 \\ 13/60 \\ 11/20 \\ 13/60 \\ 1/120 \\ 0 \end{bmatrix}$$

j=1

j=7

{v}|4

B_j(x_r)

r=1  to r=R=7

{{A}}|4 * {W}|4 = {V}|4

FIG. 6B

1000 perspective view

100-E3

100

100-E1    100-E4    100-E2

$f(x^1)$

$y^2$

$y^1$

200-E2    200-E3

200-E1    $x\_r^1$

200

**FIG. 7A**

100

$(x\_r^1, \ x\_r^2)$

$(x\_q^1, \ x\_q^2)$

FIG. 7B

design process <u>500</u>

FIG. 8

FIG. 9

| | Europäisches Patentamt / European Patent Office / Office européen des brevets | **EUROPEAN SEARCH REPORT** | **Application Number** EP 24 22 3800 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MARUSSIG BENJAMIN ET AL: "Fast immersed boundary method based on weighted quadrature", COMPUTER METHODS IN APPLIED MECHANICS AND ENGINEERING, [Online] vol. 417, 5 September 2023 (2023-09-05), page 116397, XP093261322, AMSTERDAM, NL ISSN: 0045-7825, DOI: 10.1016/j.cma.2023.116397 Retrieved from the Internet: URL:https://pdf.sciencedirectassets.com/27 1868/1-s2.0-S0045782523X00164/1-s2.0-S0045 782523005212/main.pdf?hash=fc01017f3570114 fd92e97e18d153232d53087137985057372fc5d885 6c5bbea&host=68042c943591013ac2b2430a89b27 0f6af2c76d8dfd086a07176afe7c76c2c61&pii=S0 045782523005212&tid=spdf-33ef1694-7e91-40d 9-88b7-161> [retrieved on 2025-03-20] * Abstract; pages 2-5, sections 2-3; pages 14-20, section 6 * | 1-15 | INV. G06F30/17 G06F30/23 |
| A,D | CALABRÒ F ET AL: "Fast formation of isogeometric Galerkin matrices by weighted quadrature", COMPUTER METHODS IN APPLIED MECHANICS AND ENGINEERING, NORTH-HOLLAND, AMSTERDAM, NL, vol. 316, 27 September 2016 (2016-09-27), pages 606-622, XP029925247, ISSN: 0045-7825, DOI: 10.1016/J.CMA.2016.09.013 * Abstract; pages 607-615, sections 1-4 * | 1-15 | TECHNICAL FIELDS SEARCHED (IPC) G06F |

-/--

The present search report has been drawn up for all claims

| Place of search | Date of completion of the search | Examiner |
|---|---|---|
| Munich | 21 March 2025 | Lindner, Anja |

Europäisches
Patentamt

European
Patent Office

Office européen
des brevets

## EUROPEAN SEARCH REPORT

**Application Number**

EP 24 22 3800

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | HIEMSTRA RENÉ R ET AL: "Fast formation and assembly of finite element matrices with application to isogeometric linear elasticity", COMPUTER METHODS IN APPLIED MECHANICS AND ENGINEERING, NORTH-HOLLAND, AMSTERDAM, NL, vol. 355, 27 June 2019 (2019-06-27), pages 234-260, XP085800782, ISSN: 0045-7825, DOI: 10.1016/J.CMA.2019.06.020 [retrieved on 2019-06-27] * Abstract; pages 237-248, sections 2-3; pages 252-255, section 5 * | 1-15 | |
| A | ZOU Z ET AL: "Efficient and robust quadratures for isogeometric analysis: Reduced Gauss and Gauss-Greville rules", COMPUTER METHODS IN APPLIED MECHANICS AND ENGINEERING, NORTH-HOLLAND, AMSTERDAM, NL, vol. 392, 11 February 2022 (2022-02-11), XP086997401, ISSN: 0045-7825, DOI: 10.1016/J.CMA.2022.114722 [retrieved on 2022-02-11] * Abstract; pages 1-14, sections 1-4 * | 1-15 | TECHNICAL FIELDS SEARCHED (IPC) |

The present search report has been drawn up for all claims

| Place of search | Date of completion of the search | Examiner |
|---|---|---|
| Munich | 21 March 2025 | Lindner, Anja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CALABRÒ, F.** ; **SANGALLI, G.** ; **TANI, M.** Fast formation of isogeometric Galerkin matrices by weighted quadrature. *Computer Methods in Applied Mechanics and Engineering*, 2017, vol. 316, 606-622

- **HIEMSTRA, R.R.** ; **SANGALLI, G** ; **TANI, M** ; **CALABRÒ, F.** ; **HUGHES, T.J.** Fast formation and assembly of finite element matrices with application to isogeometric linear elasticity.. *Computer Methods in Applied Mechanics and Engineering*, 2019, vol. 355, 234-260
- A practical guide to splines. **CARL DE BOOR**. Applied Mathematical Sciences. Springer-Verlag, 1978, vol. 27